(19) Europäisches Patentamt
European Patent Office
Office européen des brevets

(11) **EP 4 123 326 B1**

(12) **EUROPÄISCHE PATENTSCHRIFT**

(45) Veröffentlichungstag und Bekanntmachung des Hinweises auf die Patenterteilung:
**01.05.2024 Patentblatt 2024/18**

(21) Anmeldenummer: **21000198.8**

(22) Anmeldetag: **23.07.2021**

(51) Internationale Patentklassifikation (IPC):
**G01R 31/52** (2020.01) **H02H 3/16** (2006.01)
**H02H 3/33** (2006.01)

(52) Gemeinsame Patentklassifikation (CPC):
**G01R 31/52; H02H 3/33**

(54) **VERFAHREN ZUR REKONSTRUKTION VON FEHLERSTROM UND ABLEITSTROM AUS DEM DIFFERENZSTROM VON ODER IN MEHRLEITERSYSTEMEN**

METHOD FOR RECONSTRUCTING A FAULT CURRENT AND A LEAKAGE CURRENT FROM THE DIFFERENTIAL CURRENT OF OR IN MULTI-CONDUCTOR SYSTEMS

PROCÉDÉ DE RECONSTRUCTION DU COURANT DE DÉFAUT ET DE COURANT DE FUITE À PARTIR DU COURANT DIFFÉRENTIEL À PARTIR DE OU DANS DES SYSTÈMES À CONDUITES MULTIPLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.01.2023 Patentblatt 2023/04**

(73) Patentinhaber: **A. Eberle GmbH & Co. KG 90461 Nürnberg (DE)**

(72) Erfinder: **Hofbeck, Martin 90461 Nürnberg (DE)**

(74) Vertreter: **Schuhmann, Albrecht c/o Merten Patentmanagement Alexanderstrasse 1 90547 Stein (DE)**

(56) Entgegenhaltungen:
**EP-A1- 2 372 857     DE-A1-102011 002 084 US-B1- 6 392 422**

**Beschreibung**

Die vorliegende Erfindung betrifft ein Verfahren zur Rekonstruktion von Fehlerstrom und Ableitstrom aus dem Differenzstrom von oder in Mehrleitersystemen wie Versorgungsnetzen. In Versorgungsnetzen muss aus Gründen der elektrischen Sicherheit und des Brandschutzes die Isolation der Leiter überwacht werden.

Nach DIN VDE 0105-100/A1 (2017) darf eine wiederkehrende Isolationsprüfung der elektrischen Anlagen im betrieblichen Umfeld durch eine dauerhaft installierte Differenzstromüberwachung nach DIN EN 62020 (VDE 0663) ersetzt werden.

Meist ist eine wiederkehrende Isolationsprüfung im Umfeld einer bereits bestehenden und in Betrieb befindlichen elektrischen Verteilung nur durch erheblichen Aufwand und durch die Auftrennung der vorhandenen Installationen möglich sowie mit den damit einhergehenden Anlagenstillständen verbunden. Dies ist bei einer dauerhaften Produktion von Wirtschaftsgütern teilweise nicht umsetzbar.

Daher ist ein kontinuierliches Monitoring der Differenzströme sehr häufig die kostengünstigste, schnellste und die am verbreitetste Möglichkeit für den Anlagenbetreiber, um den einzuhaltenden rechtlichen Vorgaben nach der Betriebssicherheitsverordnung (BetrSichV) zu entsprechen.

Hierfür werden üblicherweise Differenzstromwandler verwendet, welche die Summe der Leiterströme erfassen. In einem vollständig isolierten Mehrleitersystem wäre die Summe aller Leiterströme zu jedem Zeitpunkt Null. Der Differenzstrom (engl.: Residual Current) ist der Strom, der über parasitäre Pfade das Mehrleitersystem "umgeht".

Das Verfahren beruht darauf, dass mit sogenannten Residual Current Monitoring (RCM) Geräten kontinuierlich der Effektivwert des Differenzstromes gemessen wird und bei Überschreitung bestimmter Schwellwerte entsprechende Warn- oder Alarm-Meldungen vom Gerät abgegeben werden, sodass geeignete Schutzmaßnahmen vom Personal durchgeführt werden können.

Der aktuelle Stand der Technik zur Messung des Differenzstromes ist ein einfaches True RMS Messverfahren, welches von der zuständigen Elektrofachkraft oder dem beauftragten Sachverständigen zur Prüfung nach DIN VDE 0105-100 sehr häufig viel Interpretationsvermögen abverlangt und eine objektive, korrekte Beurteilung zur Erreichung der Betriebssicherheitsverordnung nahezu unmöglich macht.

Das gängige Vorgehen beinhaltet, dass an einem zentralen Punkt des Netzes ein Messgerät zur Messung und Überwachung der Differenzströme eingesetzt wird. Bei dieser Messweise kommt es häufig vor, dass gemessene Differenzströme die Schwellen um das 10 bis 20-fache überschreiten, ohne dass dies auf tatsächliche Isolationsfehler im Versorgungssystem zurückzuführen ist.

Dies lässt sich damit erklären, dass die zentrale True RMS Messung des Differenzstromes technisch gesehen immer die Überlagerung des gesuchten Fehlerstroms mit unerwünschten Ableitströmen darstellt. Obwohl Ableitströme oft die gesamte Messung betragsmäßig dominieren, sind sie für die Ziele der Reststromüberwachung irrelevant. Der Stand der Technik ist somit durch eine geringe Selektivität ausgezeichnet und lässt es im praktischen Einsatz oft kaum zu, eine belastbare Aussage über den wahren Isolationszustand des Versorgungsnetzes zu erhalten. Bekannt sind DE 10 2011 002084 A1 und EP 2 372 857 A1, die zwei unterschiedliche Verfahren zur Bestimmung eines Fehlerstromanteils an einem Differenzstrom offenbaren, und US 6 392 422 B1 das ein weiteres Verfahren zur Fehlerstromüberwachung in einem elektrischen Wechselstromnetz offenbart.

Ein verbessertes Standardverfahren setzt daher heute schon auf die Möglichkeit, an einer Vielzahl von Verästelungsstellen des Stromnetzes weitere Strommessungen aufzubauen, um sie mit der zentralen Messung zu korrelieren. Trotz des zusätzlichen technischen und finanziellen Aufwandes leidet jedoch auch jede dieser weiteren Strommessungen im Standardverfahren immer noch unter dem prinzipbedingten Nachteil, dass es keine nennenswerte Selektivität bezüglich Fehler- und Ableitströmen gibt.

Das hier vorgestellte Verfahren weist demgegenüber klare Vorteile auf, denn es ist dazu in der Lage, den Differenzstrom mit hoher Selektivität in die beiden Komponenten - den Ableitstrom und den Fehlerstrom zu zerlegen.

Zum einen benötigt der Anwender auf Basis dieses verbesserten Verfahrens somit weniger Sensorik für eine Bewertung des Isolationszustandes. Dadurch entstehen weniger Kosten.

Zum anderen kann durch die erhöhte Selektivität gleichzeitig eine verlässlichere Bewertung der durch das neue Verfahren ermittelten Werte erzielt werden. Dies erleichtert es dem Anwender erheblich, zur korrekten Beurteilung des Isolationszustandes überwachter elektrischer Anlagen gelangen und erhöht somit deren Betriebssicherheit.

Aufgabe der vorliegenden Erfindung ist es, ein Verfahren bereitzustellen um den Differenzstrom mit hoher Selektivität in die beiden Komponenten - den Ableitstrom und den Fehlerstrom zerlegen und zur Verfügung stellen zu können.

Diese Aufgabe wird mit den Merkmalen des kennzeichnenden Teils des Anspruchs 1 gelöst. Fortbildungen und vorteilhafte Ausführungen der Erfindung sind in den weiteren Ansprüchen umfasst.

Erfindungsgemäß ist ein Verfahren zur Rekonstruktion von Fehlerstrom und Ableitstrom aus dem Differenzstrom von Mehrleitersystemen gekennzeichnet durch die folgenden Schritte:

a) Berechnung und Vorhaltung von Grundschwingung und Harmonischen von Leiter-Spannungen ($U_1$ bis $U_M$) und Differenzstrom aus den entsprechenden Abtast-Zeitreihen in einem elektrischen Netz.

b) Auswahl der Phasoren der dominierenden Harmonischen.

c) Quantifizierung der Admittanzen eines Leitungsmodells aus den Phasoren, wobei der *Phasor* der *Harmonischen n* des Stromes über die *Admittanz* $\underline{Y}_{n,m}$ des *Leiters m* bei der *Harmonischen n* ist, also
$\underline{I}_{n,m} = U_{n,m} \cdot \underline{Y}_{n,m}$ mit $\underline{U}_{n,m}$ *Phasor* der *Harmonischen n* der Spannung des *Leiters m* gegen *Bezugspotential* (z.B. Erde).

d) Rekonstruktion von Fehlerstrom und Ableitstrom aus den Admittanzen und den zugehörigen Spannungs-Phasoren bzw. den Momentanwerten der Spannungen, wobei der Effektivwert des Fehlerstoms aus den *Spannungs-Phasoren* $\underline{U}_{n,m}$ und den *Konduktanzen* $G_1...G_M$ berechnet werden kann und wobei der über alle Leiter m akkumulierte Fehlerstrom Phasor der Harmonischen lautet

$$\underline{I_F}_n = \sum_{m=1}^{M} \underline{U}_{n,m} \cdot G_m$$

Verfahrensprinzip:

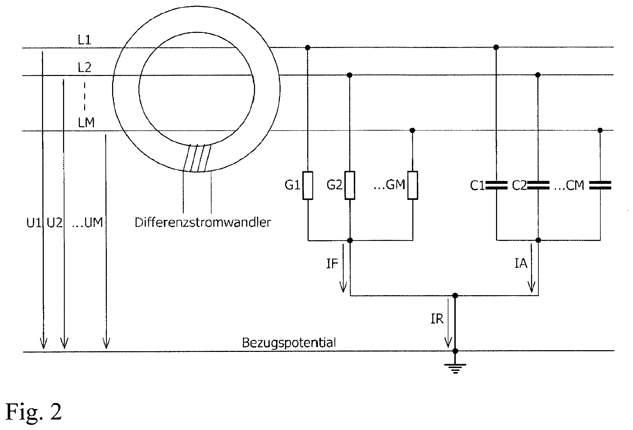

*Der Differenzstrom ist die Überlagerung von Ableitstrom und Fehlerstrom, wie in Fig. 2 gezeigt.* Der *Ableitstrom* wird durch *Suszeptanzen* (Blind-Leitwerte) zwischen Leiter und Bezugspotential (z.B. Erde) erzeugt. *Suszeptanzen* werden von normalen Netz-Eigenschaften wie z.B. den Streukapazitäten der Leiter gegen Erde oder Entstörkondensatoren (festinstallierte oder mobile Geräte) bestimmt.
Da die *Suszeptanz* mit der Frequenz linear zunimmt, können die Harmonischen des Ableitstromes hohe Werte annehmen. Dementsprechend hat der Effektivwert des Ableitstromes einen breitbandigen Charakter.
Der *Ableitstrom* liefert keine Aussage über den *Isolationszustand* und ist für die *Isolationsüberwachung* über den *Differenzstrom* als *Störgröße* zu betrachten.
Der *Fehlerstrom* wird durch *Konduktanzen* (Wirk-Leitwerte) zwischen Leiter und Bezugspotential (z.B. Erde) erzeugt. Bei idealer Isolation sind die *Konduktanzen* Null.
Mit zunehmender Degradation der Isolation steigt die *Konduktanz,* was zu einem Anstieg des *Fehlerstromes* führt.
Der *Isolationszustand* eines Mehrleitersystems wird somit durch den *Fehlerstrom* abgebildet. Der Effektivwert des *Fehlerstromes* wird von der Grundschwingung dominiert.
Der Effektivwert des *Differenzstromes* bildet den *Isolationszustand* nur *eingeschränkt* ab.
Die eigentliche *Kenngröße* für den *Isolationszustand,* der *Fehlerstrom,* wird *nicht* gemessen. Für die vektorielle Überlagerung der Spektralkomponenten von *Fehlerstrom* und *Ableitstrom* zum *Differenzstrom* gelten *keine festen Phasenbeziehungen* und infolgedessen *kein fester Zusammenhang* zwischen den Effektivwerten von *Ableitstrom, Fehlerstrom* und *Differenzstrom.* Bei der Bewertung des *Differenzstromes* kann ursächlich *nicht* zwischen den Einflüssen von *Fehlerstrom* und *Ableitstrom unterschieden* werden.
Es kann auch nicht vorausgesetzt werden, dass die *Zunahme* von *Fehlerstrom* oder *Ableitstrom* immer auch zu einer *Zunahme* des *Differenzstromes* führt oder der *Differenzstrom* größer als *Fehlerstrom* oder *Ableitstrom* ist.
*Leiterbezogene Messgrößen* sind *nicht* verfügbar.
Um Fehlalarme durch den *Ableitstrom* zu vermeiden, müssen die Auslöseschwellen für die Effektivwerte des *Differenzstromes* auf einen Wert *oberhalb des größten zu erwartenden Ableitstromes* eingestellt werden.
Dadurch ist die *Sensitivität* der *Isolationsüberwachung eingeschränkt.*
Die *Isolationsüberwachung* über den *Fehlerstrom* bietet *Vorteile* hinsichtlich *Selektivität* und *Sensitivität,* da *gezielt* die *Kenngröße* des *Isolationszustandes überwacht* wird.
Es ist dann möglich, auch *kleinere Veränderungen* des *Isolationszustandes früher* zu *erkennen.*
Das vorgestellte Verfahren ist in der Lage, die *leiterbezogenen Konduktanzen* und *Suszeptanzen* zu *quantifizieren* und daraus *Fehlerstrom* und *Ableitstrom* zu *rekonstruieren.*
Als Eingangsgrößen werden die *Phasoren von Grundschwingung und Harmonischen* der *Leiter-Spannungen* und des *Differenzstromes* verwendet. Diese Messgrößen sind üblicherweise in der Signalverarbeitung von *Power-Quality-Instrumenten* (*PQL*) bereits vorhanden, weshalb das Verfahren hier *besonders geeignet* ist.
Voraussetzung ist, dass in einem M-Leiter-Netz *neben der Grundschwingung mindestens M-1 Spannungsharmonische ausreichender Amplitude* verfügbar sind.

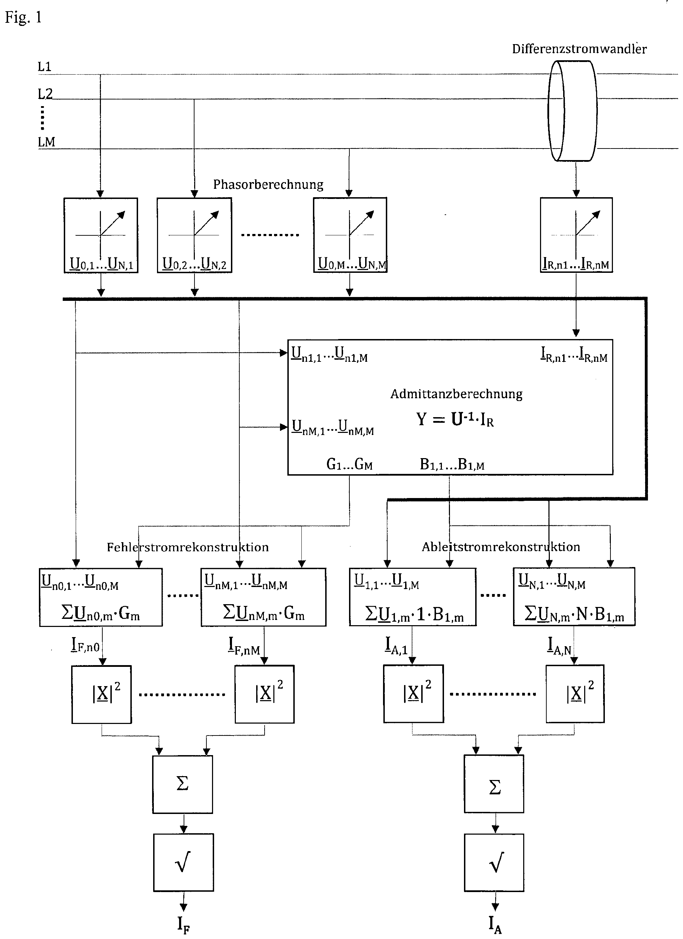

Die Berechnung erfolgt in 4 Schritten gemäß Fig. 1:

- Berechnung von *Grundschwingung und Harmonischen* von *Leiter-Spannungen* und *Differenzstrom* aus den entsprechenden Abtast-Zeitreihen.

- Auswahl der *Phasoren der dominierenden Harmonischen*

- *Quantifizierung* der *Admittanzen* (*Konduktanzen, Suszeptanzen*) eines *Leitungsmodells* aus den *Phasoren*.

- *Rekonstruktion* von *Fehlerstrom* und *Ableitstrom* aus den *Admittanzen* und den zugehörigen *Spannungs-Phasoren* bzw. den *Momentanwerten der Spannungen*.

Leitungsmodell:

Das in Fig. 2 gezeigte M-Leitersystem wird mit einem *Ersatzgrößen-Modell* beschrieben, bei dem jeder der Leiter m = 1..M eine frequenzabhängige wirksame *Admittanz* $\underline{Y}_m(\omega)$ gegen das *Bezugspotential* besitzt.
$\underline{Y}_m$ besteht aus der Parallelschaltung von *Konduktanz* $G_m$ und *Suszeptanz* $B_m$.

$$\underline{Y}_m(\omega) = G_m + j \cdot B_m(\omega) \quad \text{(Formel 1)}$$

Die *Suszeptanz* $B_m$ wird in erster Näherung von der wirksamen Kapazität $C_m$ des Leiters m gegen das *Bezugspotential* bestimmt.

$$B_m(\omega) = \omega \cdot C_m \quad \text{(Formel 2)}$$

Die Kreisfrequenz $\omega$ wird in Folge durch die Ordnungszahl n der Harmonischen der Netzfrequenz $\omega_l$ substituiert mit

$$\omega_n = n \cdot \omega_1 \quad \text{(Formel 3)}$$

Damit wird die *Suszeptanz* des *Leiters m bei der Harmonischen n* zu

$$B_{n,m} = \omega_n \cdot C_m = n \cdot \omega_1 \cdot C_m = n \cdot B_{1,m} \quad \text{(Formel 4)}$$

und die *Admittanz* des *Leiters m bei der Harmonischen n* zu

$$\underline{Y}_{n,m} = G_m + j \cdot n \cdot B_{1,m} \quad \text{(Formel 5)}$$

$B_{1,m}$ *Grundschwingungs-Suszeptanz* des *Leiters m*

Eingangsgrößen:

Das beschriebene Verfahren basiert auf den *harmonischen Phasoren* der *Leiter-Spannungen* gegen das *Bezugspotential* (z.B. Erde) und des *Differenzstromes*.
*Phasoren* sind zweidimensionale Vektoren und beschreiben die kardinalen Parameter Betrag und Phase der Sinusschwingung einer bestimmten Frequenz (z.B. Harmonische der Netzfrequenz). Sie können durch harmonische Analyse (z.B. diskrete Fourier-Transformation, DFT) aus den Abtastzeitreihen von Signalen berechnet werden.
Entsprechende Verfahren sind z.B. grundlegender Bestandteil der Signalverarbeitung von *Power-Quality-Instrumenten* (PQI).
*Phasoren* können sowohl polar (Betrag, Phase) als auch komplex (Realteil, Imaginärteil) dargestellt werden.
Der Betrag eines *Spannungsphasors* hat üblicherweise die Dimension [V], der eines *Stromphasors* die Dimension [A]. Die Phase beschreibt die Winkeldifferenz zu einer Bezugsschwingung gleicher Frequenz.

Die Genauigkeit des erfassten *Fehlerstromes* wird maßgeblich von der *Selektivität* d.h. der Fähigkeit zur Unterscheidung zwischen *Konduktanz* und *Suszeptanz* bzw. *Fehlerstrom* und *Ableitstrom* bestimmt.

Die *Selektivität* ist wesentlich von der Qualität der *harmonischen Phasoren* abhängig.

Alle *Phasoren* einer Harmonischen müssen einen *gemeinsamen Phasenbezug* haben.

Sie sollten vorteilhafterweise aus simultan abgetasteten Zeitreihen über identische Zeitfenster berechnet werden.

Die Betragsfehler der *Phasoren* sowie die Winkelfehler zwischen den *Phasoren* einer *Harmonischen* sind zu minimieren. Dazu können vorteilhafterweise frequenzabhängige (Wandler-) Korrekturfaktoren und (Wandler-)Korrekturwinkel (z.B. des Differenzstromwandlers) verwendet werden.

Quantifizierung der Admittanzen:

Der *Phasor* der *Harmonischen n* des Stromes über die *Admittanz* $\underline{Y}_{n,m}$ des *Leiters m* bei der *Harmonischen n* ist

$$\underline{I}_{n,m} = \underline{U}_{n,m} \cdot \underline{Y}_{n,m} \qquad \text{(Formel 6)}$$

mit

$U_{n,m}$ *Phasor* der *Harmonischen n* der Spannung des *Leiters m* gegen *Bezugspotential* (z.B. Erde).

Der *Phasor* der *Harmonischen n* des *Differenzstromes* $I_R$ ist die Summe der *Phasoren* der *Harmonischen n* der *Admittanz-Ströme* aller *Leiter m,* d.h. es gilt:

$$\sum_{m=1}^{M} \underline{I}_{n,m} = \sum_{m=1}^{M} \underline{U}_{n,m} \cdot \underline{Y}_{n,m} = \sum_{m=1}^{M} \underline{U}_{n,m} \cdot (G_m + j \cdot B_{n,m}) = \sum_{m=1}^{M} \underline{U}_{n,m} \cdot (G_m + j \cdot n \cdot B_{1,m}) = \underline{I_R}_n$$

(Formel 7)

Zur Ermittlung der M Wertepaare {$G_m$, $B_{1,m}$} ist ein *System von M unabhängigen komplexwertigen linearen Gleichungen* gemäß (7) erforderlich.

Dazu werden die Gleichungen gemäß (7) für M verschiedene *Harmonische n* formuliert.

*Auswahlverfahren* für die *Harmonischen n:*

Die erste Gleichung verwendet immer die *Grundschwingung:* $n_1$=1.

Die übrigen Gleichungen verwenden *vorteilhafterweise* die *Harmonischen* $n_2$ ..$n_M$, deren *Differenzstrom-Phasor-Betrag geteilt durch die Ordnungszahl n* am größten ist.

Das *Auswahlverfahren* kann *adaptiv,* d.h. *angepasst an die aktuelle Netzsituation* angewendet werden.

Das Gleichungssystem hat die allgemeine Form (Matrix-Schreibweise)

$$U \cdot Y = I_R \qquad \text{(Formel 8)}$$

Durch *Zerlegung* der M *komplexwertigen* in 2·M *reellwertige lineare Gleichungen* erhält man:

$$\begin{bmatrix} Re\{\underline{U}_{n_1,1}\} & -Im\{\underline{U}_{n_1,1}\}\cdot n_1 & \cdots & Re\{\underline{U}_{n_1,M}\} & -Im\{\underline{U}_{n_1,M}\}\cdot n_1 \\ Im\{\underline{U}_{n_1,1}\} & Re\{\underline{U}_{n_1,1}\}\cdot n_1 & \cdots & Im\{\underline{U}_{n_1,M}\} & Re\{\underline{U}_{n_1,M}\}\cdot n_1 \\ \vdots & \vdots & & \vdots & \vdots \\ Re\{\underline{U}_{n_M,1}\} & -Im\{\underline{U}_{n_M,1}\}\cdot n_M & \cdots & Re\{\underline{U}_{n_M,M}\} & -Im\{\underline{U}_{n_M,M}\}\cdot n_M \\ Im\{\underline{U}_{n_M,1}\} & Re\{\underline{U}_{n_M,1}\}\cdot n_M & \cdots & Im\{\underline{U}_{n_M,M}\} & Re\{\underline{U}_{n_M,M}\}\cdot n_M \end{bmatrix} \cdot \begin{bmatrix} G_1 \\ B_{1,1} \\ \vdots \\ G_M \\ B_{1,M} \end{bmatrix} = \begin{bmatrix} Re\{\underline{I}_{R,n_1}\} \\ Im\{\underline{I}_{R,n_1}\} \\ \vdots \\ Re\{\underline{I}_{R,n_M}\} \\ Im\{\underline{I}_{R,n_M}\} \end{bmatrix}$$

(Formel 9)

Der Lösungsvektor Y enthält die *Konduktanzen* $G_m$ und die *Suszeptanzen* $B_{l,m}$ der Leiter m = 1..M.

Das lineare Gleichungssystem kann mit den bekannten direkten (z.B. *Gauß-Elimination*) oder iterativen (z.B. Gauß-Seidel-) Verfahren unter den entsprechenden Voraussetzungen (Nichtsingularität, Konvergenz) gelöst werden.

Beispiel zur Vorgehensweise für die Lösung mit *Gauß-Elimination:*

Die *Stabilität* des Lösungsvektors Y hängt von der *Kondition des linearen Gleichungssystems* ab. Bei schlechter *Kondition* ist die numerische *Stabilität* der Lösung gering, d.h. auch relativ kleine Messfehler der Eingangsgrößen (*Phasoren*) oder Rundungsfehler führen zu größerer Streuung der Lösung.

Vor der Lösung sollte daher die *Kondition* des Gleichungssystems durch geeignete *Skalierung* verbessert werden.

Mit der anschließenden *Gauß-Elimination* wird versucht, alle Elemente unterhalb der Hauptdiagonalen von U auf Null zu bringen, wozu vorteilhafterweise die *vollständige Pivotierung* (Zeilen- und Spaltentausch) verwendet werden sollte.

Gelingt dies nicht, so ist **U** singulär, d.h. es existiert keine Lösung Y.

Andernfalls liefert der *Quotient* Q der Beträge des betragskleinsten zum betragsgrößten Element $u_{i,i}$ der Hauptdiagonalen von **U** nach der *Gauß-Elimination* einen *Schätzwert* für die numerische *Validität* der Lösung.

$$0 < Q = \frac{Min\{|u_{2,2}|...|u_{M,M}|\}}{Max\{|u_{2,2}|...|u_{M,M}|\}} \leq 1 \qquad \text{(Formel 10)}$$

Liegt Q über einem hinreichenden *Mindestwert* $Q_{min}$, so werden die Elemente des Lösungsvektors Y durch *Rücksubstitution* berechnet.

Die resultierenden Werte können *in Abhängigkeit* von der numerischen *Validität* gefiltert, aufgezeichnet und qualifiziert werden.

Wenn das Mehrleitersystem Leiter enthält, die *vernachlässigbar kleine Spannungen* gegen das Bezugspotential führen (z.B. Neutralleiter), ist die *Validität* der Lösung *signifikant größer,* wenn *diese Leiter nicht berücksichtigt* werden.

Diese Vorgehensweise ist *vorteilhafterweise immer dann* anzuwenden, wenn das Gleichungssystem unter Einbeziehung derartiger Leiter *keine hinreichend valide* Lösung hat.

Rekonstruktion des Fehlerstromes

Der *Effektivwert des Fehlerstroms* kann aus den *Spannungs-Phasoren* $\underline{U}_{n,m}$ und den (ggf. gefilterten) *Konduktanzen* $G_l...G_M$ berechnet werden.

Der über alle *Leiter m* akkumulierte *Fehlerstrom-Phasor* der *Harmonischen n* beträgt

$$\underline{I_F}_n = \sum_{m=1}^{M} \underline{U}_{n,m} \cdot G_m \qquad \text{(Formel 11)}$$

Die DC-Komponente des Fehlerstromes $n_0=0$ wird aus den DC-Komponenten $\underline{U}_{0,m}$ der Spannungen $U_m$ berechnet.

Der über die *Fehlerstrom-Phasoren* der *Harmonischen* $n_0..n_M$ ($n_0=0$) akkumulierte *effektive Fehlerstrom* $I_F$ beträgt

$$I_F = \sqrt{\sum_{m=0}^{M} \left| \underline{I_F}_{n_m} \right|^2} = \sqrt{\sum_{m=0}^{M} \left( Re\left\{ \underline{I_F}_{n_m} \right\}^2 + Im\left\{ \underline{I_F}_{n_m} \right\}^2 \right)}$$

(Formel 12)

Da das Spektrum des Fehlerstromes von der Grundschwingung dominiert wird, ist die Effektivwertbildung über die Harmonischen $n_0..n_M$ i.A. hinreichend genau.

Die *Momentanwerte des Fehlerstroms* werden aus den *Momentanwerten der Spannungen* $u_m(n)$ und den (ggf. gefilterten) *Konduktanzen* $G_I...G_M$ berechnet mit

$$i_F(n) = \sum_{m=1}^{M} u_m(n) \cdot G_m$$

(Formel 13)

Der *Effektivwert des Fehlerstroms* kann alternativ aus den *Momentanwerten* $i_F(n)$ berechnet werden.

Wenn die Spannungsmesspfade auch die DC-Komponente übertragen, enthalten die so rekonstruierten Fehlerströme ebenfalls die DC-Komponente.

Dies ist unabhängig davon, ob der Differenzstromwandler DC übertragen kann oder nicht, da die DC-Komponente des Differenzstromes nicht in die Fehlerstromberechnung eingeht.

Somit ist die Überwachung des Differenzstromwandler-Anschlusses mit *niederfrequenten Testsignalen* unterhalb der Grundschwingung möglich, *ohne dass diese Signale in den rekonstruierten Fehlerströmen sichtbar sind.*

Wird die DC-Komponente in den Spannungsmesspfaden nicht übertragen, so kann anstelle der mit (11) berechneten DC-Komponente des Fehlerstromes die DC-Komponente des Differenzstromes verwendet werden, sofern ein DC-fähiger Differenzstromwandler verfügbar ist.

In diesem Fall wären Anschluss-Testsignale in den rekonstruierten Fehlerströmen sichtbar.

Rekonstruktion des Ableitstromes

Der *Effektivwert des Ableitstroms* kann aus den *Spannungs-Phasoren* $U_{n,m}$ und den (ggf. gefilterten) *Suszeptanzen* $B_{I,I}...B_{I,M}$ berechnet werden.

Der über alle *Leiter m* akkumulierte *Ableitstrom-Phasor* der *Harmonischen n* beträgt

$$\underline{I_A}_n = \sum_{m=1}^{M} \underline{U}_{n,m} \cdot n \cdot B_{1,m}$$

(Formel 14)

Der über die *Ableitstrom-Phasoren* der *Harmonischen* 1..N akkumulierte *effektive Ableitstrom* $I_A$ beträgt

$$I_A = \sqrt{\sum_{n=1}^{N} \left| \underline{I_A}_n \right|^2} = \sqrt{\sum_{n=1}^{N} \left( Re\left\{ \underline{I_A}_n \right\}^2 + Im\left\{ \underline{I_A}_n \right\}^2 \right)}$$

(Formel 15)

Bei der Effektivwertbildung sind alle Harmonischen mit signifikanten Beträgen zu berücksichtigen.

Die *Momentanwerte des Ableitstroms* werden aus den *Momentanwerten der Spannungen* $u_m(n)$ und den (ggf. gefilterten) *Suszeptanzen* $B_{1,I}...B_{1,M}$ berechnet mit

$$i_A(n) = \frac{f_S}{\omega_1} \cdot \sum_{m=1}^{M} \left( u_m(n) - u_m(n-1) \right) \cdot B_{1,m}$$

(Formel 16)

$f_S$   Abtastfrequenz

$\omega_1$   Netzfrequenz (bei Admittanzberechnung)

Der *Effektivwert des Ableitstroms* kann alternativ aus den *Momentanwerten* $i_A(n)$ berechnet werden.

Beispiel für Gleichungssysteme für 4-Leiter-System

| | |
|---|---|
| Leitersystem: | $M = 4$ |
| Phasoren der Phasen-Leiterspannungen: | $\underline{U}_{n,1}$, $\underline{U}_{n,2}$, $U_{n,3}$ |
| Phasoren der Neutralleiterspannung: | $\underline{U}_{n,4}$ |
| Phasoren des Differenzstromes: | $\underline{I}_{R,n}$ |
| Harmonische $n_m$: | $n_1 = 1$ |
| | $n_2 = 3$ |
| | $n_3 = 5$ |
| | $n_4 = 7$ |

Gleichungssystem:

$$
\begin{bmatrix}
Re\{\underline{U}_{1,1}\} & -Im\{\underline{U}_{1,1}\} & Re\{\underline{U}_{1,2}\} & -Im\{\underline{U}_{1,2}\} & Re\{\underline{U}_{1,3}\} & -Im\{\underline{U}_{1,3}\} & Re\{\underline{U}_{1,4}\} & -Im\{\underline{U}_{1,4}\} \\
Im\{\underline{U}_{1,1}\} & Re\{\underline{U}_{1,1}\} & Im\{\underline{U}_{1,2}\} & Re\{\underline{U}_{1,2}\} & Im\{\underline{U}_{1,3}\} & Re\{\underline{U}_{1,3}\} & Im\{\underline{U}_{1,4}\} & Re\{\underline{U}_{1,4}\} \\
Re\{\underline{U}_{3,1}\} & -Im\{\underline{U}_{3,1}\}\cdot 3 & Re\{\underline{U}_{3,2}\} & -Im\{\underline{U}_{3,2}\}\cdot 3 & Re\{\underline{U}_{3,3}\} & -Im\{\underline{U}_{3,3}\}\cdot 3 & Re\{\underline{U}_{3,4}\} & -Im\{\underline{U}_{3,4}\}\cdot 3 \\
Im\{\underline{U}_{3,1}\} & Re\{\underline{U}_{3,1}\}\cdot 3 & Im\{\underline{U}_{3,2}\} & Re\{\underline{U}_{3,2}\}\cdot 3 & Im\{\underline{U}_{3,3}\} & Re\{\underline{U}_{3,3}\}\cdot 3 & Im\{\underline{U}_{3,4}\} & Re\{\underline{U}_{3,4}\}\cdot 3 \\
Re\{\underline{U}_{5,1}\} & -Im\{\underline{U}_{5,1}\}\cdot 5 & Re\{\underline{U}_{5,2}\} & -Im\{\underline{U}_{5,2}\}\cdot 5 & Re\{\underline{U}_{5,3}\} & -Im\{\underline{U}_{5,3}\}\cdot 5 & Re\{\underline{U}_{5,4}\} & -Im\{\underline{U}_{5,4}\}\cdot 5 \\
Im\{\underline{U}_{5,1}\} & Re\{\underline{U}_{5,1}\}\cdot 5 & Im\{\underline{U}_{5,2}\} & Re\{\underline{U}_{5,2}\}\cdot 5 & Im\{\underline{U}_{5,3}\} & Re\{\underline{U}_{5,3}\}\cdot 5 & Im\{\underline{U}_{5,4}\} & Re\{\underline{U}_{5,4}\}\cdot 5 \\
Re\{\underline{U}_{7,1}\} & -Im\{\underline{U}_{7,1}\}\cdot 7 & Re\{\underline{U}_{7,2}\} & -Im\{\underline{U}_{7,2}\}\cdot 7 & Re\{\underline{U}_{7,3}\} & -Im\{\underline{U}_{7,3}\}\cdot 7 & Re\{\underline{U}_{7,4}\} & -Im\{\underline{U}_{7,4}\}\cdot 7 \\
Im\{\underline{U}_{7,1}\} & Re\{\underline{U}_{7,1}\}\cdot 7 & Im\{\underline{U}_{7,2}\} & Re\{\underline{U}_{7,2}\}\cdot 7 & Im\{\underline{U}_{7,3}\} & Re\{\underline{U}_{7,3}\}\cdot 7 & Im\{\underline{U}_{7,4}\} & Re\{\underline{U}_{7,4}\}\cdot 7
\end{bmatrix}
\begin{bmatrix}
G_1 \\ B_{1,1} \\ G_1 \\ B_{1,2} \\ G_2 \\ B_{1,3} \\ G_4 \\ B_{1,4}
\end{bmatrix}
=
\begin{bmatrix}
Re\{\underline{I}_{R,1}\} \\ Im\{\underline{I}_{R,1}\} \\ Re\{\underline{I}_{R,3}\} \\ Im\{\underline{I}_{R,3}\} \\ Re\{\underline{I}_{R,5}\} \\ Im\{\underline{I}_{R,5}\} \\ Re\{\underline{I}_{R,7}\} \\ Im\{\underline{I}_{R,7}\}
\end{bmatrix}
$$

| | |
|---|---|
| Leitersystem: | $M = 4 - 1$ |
| Phasoren der Phasen-Leiterspannungen: | $\underline{U}_{n,1}$, $\underline{U}_{n,2}$, $U_{n,3}$ |
| Phasoren der Neutralleiterspannung: | entfallen |
| Phasoren des Differenzstromes: | $\underline{I}_{R,n}$ |
| Harmonische $n_m$: | $n_1 = 1$ |
| | $n_2 = 3$ |
| | $n_3 = 5$ |
| | $n_4$ entfällt |

Gleichungssystem:

$$
\begin{bmatrix}
Re\{\underline{U}_{1,1}\} & -Im\{\underline{U}_{1,1}\} & Re\{\underline{U}_{1,2}\} & -Im\{\underline{U}_{1,2}\} & Re\{\underline{U}_{1,3}\} & -Im\{\underline{U}_{1,3}\} \\
Im\{\underline{U}_{1,1}\} & Re\{\underline{U}_{1,1}\} & Im\{\underline{U}_{1,2}\} & Re\{\underline{U}_{1,2}\} & Im\{\underline{U}_{1,3}\} & Re\{\underline{U}_{1,3}\} \\
Re\{\underline{U}_{3,1}\} & -Im\{\underline{U}_{3,1}\}\cdot 3 & Re\{\underline{U}_{3,2}\} & -Im\{\underline{U}_{3,2}\}\cdot 3 & Re\{\underline{U}_{3,3}\} & -Im\{\underline{U}_{3,3}\}\cdot 3 \\
Im\{\underline{U}_{3,1}\} & Re\{\underline{U}_{3,1}\}\cdot 3 & Im\{\underline{U}_{3,2}\} & Re\{\underline{U}_{3,2}\}\cdot 3 & Im\{\underline{U}_{3,3}\} & Re\{\underline{U}_{3,3}\}\cdot 3 \\
Re\{\underline{U}_{5,1}\} & -Im\{\underline{U}_{5,1}\}\cdot 5 & Re\{\underline{U}_{5,2}\} & -Im\{\underline{U}_{5,2}\}\cdot 5 & Re\{\underline{U}_{5,3}\} & -Im\{\underline{U}_{5,3}\}\cdot 5 \\
Im\{\underline{U}_{5,1}\} & Re\{\underline{U}_{5,1}\}\cdot 5 & Im\{\underline{U}_{5,2}\} & Re\{\underline{U}_{5,2}\}\cdot 5 & Im\{\underline{U}_{5,3}\} & Re\{\underline{U}_{5,3}\}\cdot 5
\end{bmatrix}
\begin{bmatrix}
G_1 \\ B_{1,1} \\ G_2 \\ B_{1,2} \\ G_3 \\ B_{1,3}
\end{bmatrix}
=
\begin{bmatrix}
Re\{\underline{I}_{R,1}\} \\ Im\{\underline{I}_{R,1}\} \\ Re\{\underline{I}_{R,3}\} \\ Im\{\underline{I}_{R,3}\} \\ Re\{\underline{I}_{R,5}\} \\ Im\{\underline{I}_{R,5}\}
\end{bmatrix}
$$

Nachdem bevorzugte Ausführungen der Erfindung in Bezug auf die beiliegenden Zeichnungen beschrieben wurden, ist festzuhalten, dass die Erfindung nicht auf diese genauen Ausführungen beschränkt ist und dass verschiedene

**EP 4 123 326 B1**

Änderungen und Modifizierungen daran von einem Fachmann ausgeführt werden können, ohne dass vom Umfang der Erfindung, wie er in den beiliegenden Ansprüchen definiert ist abgewichen wird.

**Patentansprüche**

1. Verfahren zur Rekonstruktion von Fehlerstrom und Ableitstrom aus dem Differenzstrom von Mehrleitersystemen wobei das Verfahren die folgenden Schritte umfasst:

   a) Berechnung und Vorhaltung von Grundschwingung und Harmonischen von Leiter-Spannungen , $U_1$ bis $U_M$, und Differenzstrom aus den entsprechenden Abtast-Zeitreihen in einem elektrischen Netz.
   b) Auswahl der Phasoren der dominierenden Harmonischen.
   c) Quantifizierung der Admittanzen eines Leitungsmodells aus den Phasoren, wobei $I_{n,m}$ der *Phasor* der *Harmonischen n* des Stromes über die *Admittanz* $\underline{Y}_{n,m}$ des *Leiters m bei der Harmonischen n* ist, also
   $\underline{I}_{n,m} = \underline{U}_{n,m} \cdot \underline{Y}_{n,m}$ mit $\underline{U}_{n,m}$ *Phasor* der *Harmonischen n* der Spannung des *Leiters m* gegen *Bezugspotential* (z.B. Erde)
   d) Rekonstruktion von Fehlerstrom und Ableitstrom aus den Admittanzen und den zugehörigen Spannungs-Phasoren oder aus den Admittanzen und den Momentanwerten der Spannungen, wobei der Effektivwert des Fehlerstoms aus den *Spannungs-Phasoren* $\underline{U}_{n,m}$ und den *Konduktanzen* $G_I...G_M$ berechnet werden kann und wobei der über alle Leiter m akkumulierte Fehlerstrom Phasor der Harmonischen n lautet

$$\underline{I_F}_n = \sum_{m=1}^{M} \underline{U}_{n,m} \cdot G_m$$

wobei Folgendes gilt:

Die DC-Komponente des Fehlerstromes $n_0=0$ wird aus den DC-Komponenten $\underline{U}_{0,m}$ der Spannungen $U_m$ berechnet.
Der über die *Fehlerstrom-Phasoren* der *Harmonischen* $n_0..n_M$ akkumulierte *effektive Fehlerstrom* $I_F$ wird berechnet als

$$I_F = \sqrt{\sum_{m=0}^{M} \left| \underline{I_F}_{n_m} \right|^2} = \sqrt{\sum_{m=0}^{M} \left( Re\left\{\underline{I_F}_{n_m}\right\}^2 + Im\left\{\underline{I_F}_{n_m}\right\}^2 \right)}$$

Die Momentanwerte des Fehlerstroms werden aus den Momentanwerten der Spannungen $u_m(n)$ und den Konduktanzen $G_I ... G_M$ berechnet mit

$$i_F(n) = \sum_{m=1}^{M} u_m(n) \cdot G_m$$

Der *Effektivwert des Fehlerstroms* kann alternativ aus den *Momentanwerten* $i_F(n)$ berechnet werden.
Der *Effektivwert des Ableitstroms* kann aus den *Spannungs-Phasoren* $\underline{U}_{n,m}$ und den *Suszeptanzen* $B_{I,I}...B_{I,M}$ berechnet werden.
Der über alle *Leiter m* akkumulierte *Ableitstrom-Phasor* der *Harmonischen n* beträgt

$$\underline{I_A}_n = \sum_{m=1}^{M} \underline{U}_{n,m} \cdot n \cdot B_{L,m}$$

Der über die *Ableitstrom-Phasoren* der *Harmonischen* 1..N akkumulierte *effektive Ableitstrom* $I_A$ beträgt

9

$$I_A = \sqrt{\sum_{n=1}^{N} \left| \underline{I_A}_n \right|^2} = \sqrt{\sum_{n=1}^{N} \left( Re\left\{ \underline{I_A}_n \right\}^2 + Im\left\{ \underline{I_A}_n \right\}^2 \right)}$$

Bei der Effektivwertbildung werden alle Harmonischen mit signifikanten Beträgen berücksichtigt.

Die *Momentanwerte des Ableitstroms* werden aus den *Momentanwerten der Spannungen* $u_m(n)$ und den *Suszeptanzen* $B_{1,1}...B_{1,M}$ berechnet mit

$$i_A(n) = \frac{f_S}{\omega_1} \cdot \sum_{m=1}^{M} \left( u_m(n) - u_m(n-1) \right) \cdot B_{1,m}$$

, wobei $\omega_1$ die Netzfrequenz ist und $f_s$ die Abtastfrequenz ist.

Der *Effektivwert des Ableitstroms* kann alternativ aus den *Momentanwerten* $i_A(n)$ berechnet werden.

2. Verfahren zur Rekonstruktion von Fehlerstrom und Ableitstrom nach Anspruch 1, **dadurch gekennzeichnet, dass** der Phasor der Harmonischen n des Diffenzstromes $\underline{I_R}$ die Summe der *Phasoren* der *Harmonischen n* der *Admittanz-Ströme* aller *Leiter m ist und* es gilt:

$$\sum_{m=1}^{M} \underline{I}_{n,m} = \sum_{m=1}^{M} \underline{U}_{n,m} \cdot \underline{Y}_{n,m} = \sum_{m=1}^{M} \underline{U}_{n,m} \cdot \left( G_m + j \cdot B_{n,m} \right) = \sum_{m=1}^{M} \underline{U}_{n,m} \cdot \left( G_m + j \cdot n \cdot B_{1,m} \right) = \underline{I_R}_n$$

3. Verfahren zur Rekonstruktion von Fehlerstrom und Ableitstrom nach Anspruch 1 und 2, **dadurch gekennzeichnet, dass** zur Ermittlung der M Wertepaare $\{G_m, B_{1,m}\}$ ein *System von M unabhängigen komplexwertigen linearen Gleichungen* verwendet wird. Hierzu werden die vorgenannten Gleichungen für M verschiedene *Harmonische n* formuliert und das Gleichungssystem hat die allgemeine Form in Matrix-Schreibweise $U \cdot Y = I_R$

4. Verfahren zur Rekonstruktion von Fehlerstrom und Ableitstrom nach Anspruch 1 bis 3, **dadurch gekennzeichnet, dass** der Lösungsvektor Y die *Konduktanzen* $G_m$ und die *Suszeptanzen* $B_{l,m}$ der Leiter m = 1..M enthält.

5. Verfahren zur Rekonstruktion von Fehlerstrom und Ableitstrom nach wenigstens einem der vorgenannten Ansprüche,
**dadurch gekennzeichnet, dass** das lineare Gleichungssystem mit den bekannten direkten z.B. Gauß -Elimination oder iterativen z.B. Gauß -Seidel Verfahren unter den entsprechenden Voraussetzungen wie z.B. Nichtsingularität oder Konvergenz gelöst wird.

**Claims**

1. A method for reconstructing the fault current and leakage current from the differential current of multi-conductor systems, **characterized by** the following steps:

   a) Calculating and storing the fundamental and harmonics of conductor voltages ($U_1$ to $U_M$) and the differential current from the corresponding sampling time series in an electrical network.
   b) Selecting the phasors of the dominant harmonics.
   c) Quantifying the admittances of a conduction model from the phasors, where $I_{n,m}$ is the *phasor* of the *harmonic n* of the current through the *admittance* $\underline{Y}_{n,m}$ of the *conductor m at the harmonic n*, i.e.
   $\underline{I}_{n,m} = \underline{U}_{n,m} \cdot \underline{Y}_{n,m}$ with $\underline{U}_{n,m}$ *phasor* of the *harmonic n* of the voltage of the *conductor m* with respect to *reference potential* (e.g. earth)
   d) reconstructing the fault current and leakage current from the admittances and the associated voltage phasors or from the admittances and the instantaneous values of the voltages, wherein the rms value of the fault current can be calculated from the *voltage phasors* $\underline{U}_{n,m}$ and the *conductances* $G_l...G_M$, and wherein the fault current phasor of the harmonic n accumulated over all conductors m is given by

$$\underline{I_F}_{\,n} = \sum_{m=1}^{M} \underline{U}_{n,m} \cdot G_m$$

wherein the following statements are true:

The DC component of the fault current $n_0=0$ is calculated from the DC components $\underline{U}_{0,m}$ of the voltages $U_m$. The *rms fault current* $I_F$ accumulated over the *fault current phasors* of the *harmonics* $n_0...n_M$ ($n_0=0$) is calculated as

$$I_F = \sqrt{\sum_{m=0}^{M} \left| \underline{I_F}_{\,n_m} \right|^2} = \sqrt{\sum_{m=0}^{M} \left( Re\{\underline{I_F}_{\,n_m}\}^2 + Im\{\underline{I_F}_{\,n_m}\}^2 \right)}$$

The instantaneous values of the fault current are calculated from the instantaneous values of the voltages $u_m(n)$ and the conductances $G_l...G_M$ with

$$i_F(n) = \sum_{m=1}^{M} u_m(n) \cdot G_m$$

The *rms value of the fault current* can alternatively be calculated from the *instantaneous values* $i_F(n)$.
The *rms value of the leakage current* can be calculated from the *voltage phasors* $U_{n,m}$ and the *susceptances* $B_{l,l}$ to $B_{l,M}$.
The *leakage current phasor* of the *harmonic n* accumulated over all *conductors m* amounts to

$$\underline{I_A}_{\,n} = \sum_{m=1}^{M} \underline{U}_{n,m} \cdot n \cdot B_{1,m}$$

The *rms leakage current* $I_A$ accumulated over the *leakage current phasors* of the *harmonics* 1..N amounts to

$$I_A = \sqrt{\sum_{n=1}^{N} \left| \underline{I_A}_{\,n} \right|^2} = \sqrt{\sum_{n=1}^{N} \left( Re\{\underline{I_A}_{\,n}\}^2 + Im\{\underline{I_A}_{\,n}\}^2 \right)}$$

All harmonics with significant magnitudes are taken into account when forming the rms value. The *instantaneous values of the leakage current* are calculated from the *instantaneous values of the voltages* $u_m(n)$ and the *susceptances* $B_{l,l}$ to $B_{l,m}$ with

$$i_A(n) = \frac{f_S}{\omega_1} \cdot \sum_{m=1}^{M} \left( u_m(n) - u_m(n-1) \right) \cdot B_{1,m}$$

where $\omega_1$ is the network frequency and $f_s$ is the sampling frequency.

The *rms value of the leakage current* can alternatively be calculated from the *instantaneous values* $i_A(n)$.

2. The method for reconstructing the fault current and leakage current according to Claim 1, **characterized in that** the phasor of the harmonic n of the differential current $\underline{I_R}$ is the sum of the *phasors* of the *harmonic n* of the *admittance* currents of all *conductors m* and the following is true:

$$\sum_{m=1}^{M} \underline{I}_{n,m} = \sum_{m=1}^{M} \underline{U}_{n,m} \cdot \underline{Y}_{n,m} = \sum_{m=1}^{M} \underline{U}_{n,m} \cdot \left(G_m + j \cdot B_{n,m}\right) = \sum_{m=1}^{M} \underline{U}_{n,m} \cdot \left(G_m + j \cdot n \cdot B_{1,m}\right) = \underline{I_R}_n$$

3. The method for reconstructing the fault current and leakage current according to Claim 1 and 2, **characterized in that**
a *system of M independent complex-valued linear equations* is used to determine the M value pairs $\{G_m, B_{l,m}\}$. For this purpose, the above-mentioned equations for M different *harmonics n* are formulated and the system of equations has the general form $U \cdot Y = I_R$ in matrix notation.

4. The method for reconstructing the fault current and leakage current according to Claims 1 to 3, **characterized in that**
the solution vector Y contains the *conductances* $G_m$ and the *susceptances* $B_{l,m}$ of the conductors m = 1...M.

5. The method for reconstructing the fault current and leakage current according to at least one of the preceding claims, **characterized in that**
the linear system of equations is solved with the known direct (e.g. Gauss elimination) or iterative (e.g. Gauss-Seidel) methods under the corresponding preconditions, such as non-singularity or convergence.

## Revendications

1. Procédé de reconstruction de courant de défaut et de courant de fuite à partir du courant différentiel de systèmes multiconducteurs **caractérisé par** les étapes suivantes de :

a) calcul et conservation des oscillations fondamentales et des harmoniques des tensions des conducteurs ($U_l$ à $U_M$) et du courant différentiel à partir de la série temporelle d'échantillonnage correspondante dans un réseau électrique.
b) sélection des phaseurs des harmoniques dominantes.
c) quantification des admittances d'un modèle de ligne à partir des phaseurs, où $I_{n,m}$ est le phaseur de l'harmonique n du courant via l'admittance $Y_{n,m}$ du conducteur m à l'harmonique n, soit
$\underline{I}_{n,m} = \underline{U}_{n,m} \cdot \underline{Y}_{n,m}$ avec $U_{n,m}$ phaseur de l'harmonique n la tension du conducteur m par rapport au potentiel de référence (par exemple la terre)
d) reconstruction du courant de défaut et du courant de fuite à partir des admittances et des phaseurs de tension associés ou des valeurs instantanées des tensions, moyennant quoi la valeur efficace du courant de défaut peut être calculée à partir des phaseurs de tension $U_{n,m}$ et des conductances $G_l...G_M$ et dans lequel le m phaseur de courant de défaut accumulé via tous les conducteurs des harmoniques n est

$$\underline{I_F}_n = \sum_{m=1}^{M} \underline{U}_{n,m} \cdot G_m$$

La composante continue du courant de défaut $n_0=0$ est calculée à partir des composantes continues $U_{0,m}$ des tensions $U_m$.
Le courant de défaut effectif $I_F$ accumulé via les phaseurs de courant de défaut des harmoniques $n_0..n_M$ ($n_0=0$) est

$$I_F = \sqrt{\sum_{m=0}^{M} \left|\underline{I_F}_{n_m}\right|^2} = \sqrt{\sum_{m=0}^{M} \left(Re\left\{\underline{I_F}_{n_m}\right\}^2 + Im\left\{\underline{I_F}_{n_m}\right\}^2\right)}$$

Les valeurs instantanées du courant de défaut sont calculées à partir des valeurs instantanées des tensions $u_m(n)$ et des conductances $G_l...G_M$

$$i_F(n) = \sum_{m=1}^{M} u_m(n) \cdot G_m$$

La *valeur efficace du courant de défaut* peut en variante être calculée à partir des *valeurs instantanées* $i_F(n)$.
La *valeur efficace du courant de fuite* peut être calculée à partir des *phaseurs de tension* $U_{n,m}$ et des *susceptances* $B_{1,l}...B_{l,M}$.
Le phaseur de courant de fuite m des harmoniques n accumulés via tous les conducteurs est

$$\underline{I_A}_n = \sum_{m=1}^{M} \underline{U}_{n,m} \cdot n \cdot B_{1,m}$$

Le courant de fuite effectif la accumulé via les phaseurs de courant de fuite des harmoniques 1..N est

$$I_A = \sqrt{\sum_{n=1}^{N} \left| \underline{I_A}_n \right|^2} = \sqrt{\sum_{n=1}^{N} \left( Re\left\{\underline{I_A}_n\right\}^2 + Im\left\{\underline{I_A}_n\right\}^2 \right)}$$

Lors de la détermination de la valeur efficace, tous les harmoniques ayant des valeurs significatives doivent être pris en compte.
Les valeurs instantanées du courant de fuite sont calculées à partir des valeurs instantanées des tensions $u_m(n)$ et des susceptances $B_{l,l}...B_{l,M}$

$$i_A(n) = \frac{f_S}{\omega_1} \cdot \sum_{m=1}^{M} \left( u_m(n) - u_m(n-1) \right) \cdot B_{1,m}$$

La valeur efficace du courant de fuite peut en variante être calculée à partir des valeurs instantanées iA(n).

2. Procédé de reconstruction du courant de défaut et du courant de fuite selon la revendication 1, **caractérisé en ce que** le phaseur des harmoniques n du courant de différence $I_R$ est la somme des phaseurs des harmoniques n des courants d'admittance de tous les conducteurs m et cela s'applique :

$$\sum_{m=1}^{M} \underline{I}_{n,m} = \sum_{m=1}^{M} \underline{U}_{n,m} \cdot \underline{Y}_{n,m} = \sum_{m=1}^{M} \underline{U}_{n,m} \cdot \left( G_m + j \cdot B_{n,m} \right) = \sum_{m=1}^{M} \underline{U}_{n,m} \cdot \left( G_m + j \cdot n \cdot B_{1,m} \right) = \underline{I_R}_n$$

3. Procédé de reconstruction du courant de défaut et du courant de fuite selon les revendications 1 et 2, **caractérisé en ce qu'**un système de M équations linéaires indépendantes à valeurs complexes est utilisé pour déterminer les M paires de valeurs $\{G_m, B_{1,m}\}$. A cet effet, les équations précitées sont formulées pour M harmoniques n différentes et le système d'équations possède la forme générale (notation matricielle) $U \cdot Y = I_R$

4. Procédé de reconstruction du courant de défaut et du courant de fuite selon les revendications 1 à 3, **caractérisé en ce que** le vecteur de solution Y contient les conductances $G_m$ et les susceptances $B_{l,m}$ du conducteur m = 1..M.

5. Procédé de reconstruction d'un courant de défaut et d'un courant de fuite selon au moins une des revendications précédentes, **caractérisé en ce que** le système linéaire d'équations est résolu en utilisant les méthodes connues directes (par exemple élimination de Gauss) ou itératives (par exemple Gauss-Seidel) dans les conditions appropriées (non-singularité, convergence).

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011002084 A1
- EP 2372857 A1
- US 6392422 B1